(19) Europäisches Patentamt
European Patent Office
Office européen des brevets

(11) EP 4 194 979 B1

(12) **EUROPEAN PATENT SPECIFICATION**

(45) Date of publication and mention of the grant of the patent:
**12.02.2025 Bulletin 2025/07**

(21) Application number: **21213428.2**

(22) Date of filing: **09.12.2021**

(51) International Patent Classification (IPC):
***G06N 3/0464*** *(2023.01)* ***G06N 3/084*** *(2023.01)*
***G06N 5/04*** *(2023.01)* ***G05B 23/02*** *(2006.01)*
***G01R 31/34*** *(2020.01)*

(52) Cooperative Patent Classification (CPC):
**G05B 23/024; G01R 31/343; G06N 3/0464; G06N 3/084;** G05B 2219/37351; G05B 2219/37434; G05B 2219/37435; G06N 5/041

(54) **SYSTEM, PROGRAM AND METHOD FOR MONITORING CONDITION OF AN ELECTROMECHANICAL SYSTEM**

SYSTEM, PROGRAMM UND VERFAHREN ZUR ÜBERWACHUNG DES ZUSTANDES EINES ELEKTROMECHANISCHEN SYSTEMS

SYSTÈME, LOGICIEL ET PROCÉDÉ DE SURVEILLANCE DE L'ÉTAT D'UN SYSTÈME ÉLECTROMÉCANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**14.06.2023 Bulletin 2023/24**

(73) Proprietor: **Siemens Aktiengesellschaft**
**80333 München (DE)**

(72) Inventors:
- **NAIR, P. V. Sudev**
  **560078 Bangalore, Karnataka (IN)**
- **MALIK, Vincent**
  **80636 München (DE)**
- **ZETTNER, Jürgen**
  **90587 Veitsbronn (DE)**

(74) Representative: **Patentanwaltskanzlei WILHELM & BECK**
**Prinzenstraße 13**
**80639 München (DE)**

(56) References cited:
**EP-A1- 3 904 988**

- **BRITO LUCAS C ET AL: "An explainable artificial intelligence approach for unsupervised fault detection and diagnosis in rotating machinery", MECHANICAL SYSTEMS AND SIGNAL PROCESSING, ELSEVIER, AMSTERDAM, NL, vol. 163, 17 June 2021 (2021-06-17), XP086717353, ISSN: 0888-3270, [retrieved on 20210617], DOI: 10.1016/J.YMSSP.2021.108105**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 194 979 B1

## Description

The present invention relates to condition monitoring, and more particularly relates to a system and method for monitoring condition of an electromechanical system.

Rotating machinery driven by low or medium voltage AC induction motors are used in many industrial applications in the oil and gas sectors, mining sector, marine sector, airports and other logistical centers. These motors may be used to actuate pumps, compressors, conveyors, blowers or fans, rolling mills, etc. With a typical annual failure rate of up to 7% and 20-25% of motors being critical to operations, they have a large impact on downtime and consequent financial losses. In fact, failure of motors are a major reason behind unplanned down-time.

At present, condition monitoring systems based on vibration measurements are used for monitoring health condition of motors. More specifically, anomalies are detected based on vibration levels exceeding a threshold limit during operation of the motor. The vibrations are measured at different locations on the motor using a vibration sensor such as accelerometer. In case of misaligned rotor and resultant airgap eccentricity, vibrations are most intense on the rotor of the induction motor. But, it may not be practically possible to mount the vibration sensor on the rotor in most cases. Moreover, vibration sensors that are typically located on the outer casing of the induction motor may not measure the vibrations accurately. Further, in industrial applications such as packaging machinery which require multiple motors, monitoring based on vibration is expensive. Further, maintenance of the motors is also critical in such applications. Further to the above, implementation of such condition monitoring systems to brownfield applications is difficult.

Motor Current Signature Analysis (MCSA) is widely employed to identify faults in motors. At present, MCSA uses a data-driven approach for modelling of the induction motor. However, current spectra obtained from MCSA of different motors might differ in real-world due to several factors like air-gap, overall stiffness especially load-dependent bearing stiffness, foundation and vibrational resonances. Therefore, interpretation and generalization of results from MCSA is difficult.

From document BRITO LUCAS C ET AL. :"An explainable artificial intelligence approach for unsupervised fault detection and diagnosis in rotating machinery", MECHANICAL SYSTEMS AND SIGNAL PROCESSING, ELSEVIER, AMSTERDAM, NL, vol. 163, 17 Jine 2021 (2021-06-17), XP086717353, ISSN: 0888-3270, DOI: 10.1016/J.YMSSP.2021.108105 an explainable artificial intelligence approach for unsupervised fault detection and diagnosis in rotating machinery is known. From document EP 3 904 988 A1 a method for induction motor condition monitoring using machine learning is known.

In light of the above, there exists a need for a system and method to identify and interpret current signature of an electromechanical system while taking into consideration diverse factors that may have an impact on the current signature.

Disclosed herein is a system and method for monitoring condition of an electromechanical system using an Explainable Artificial Intelligence (xAI) system, according to claim 1. All features of the independent claims are mandatory features of the current invention. Accordingly, the method comprises analyzing, by a processing unit, a set of parameters associated with the electromechanical system using the xAI system. The set of parameters include at least a load, a rotational speed and one or more spectral features associated with a current spectrum of the electromechanical system. The xAI system comprises a prediction model and an explanation model. In an embodiment, the prediction model is a temporal convolutional network. In an embodiment, the explanation model is a deep neural network based on Layer-wise Relevance Propagation algorithm. The step of analyzing the set of parameters comprises determining a misalignment probability based on the set of parameters using the prediction model. Further, parameter relevancies corresponding to each of the parameters is determined, based on the misalignment probability, using the explanation model.

Advantageously, the present invention provides physics-based explanations for spectral lines in a current spectrum of an electromechanical system.

According to the invention, the method further comprises generating the current spectrum of the electromechanical system, through at least one simulation of the electromechanical system. The step of generating the current spectrum of the electromechanical system through the at least one simulation comprises firstly, determining a vibration level of a rotor of the electromechanical system based on operational data associated with the electromechanical system. The operational data comprises at least one of the parameters and is received from at least one source associated with the electromechanical system. Further, an electromagnetic simulation model is configured based on the vibration level. The electromagnetic simulation model is further executed in a simulation environment to determine changes in a magnetic flux distribution within the electromechanical system. The current spectrum is generated based on the changes in the magnetic flux distribution.

According to the invention, determining the vibration level of the rotor of the electromechanical system based on the operational data comprises firstly, estimating a dynamic misalignment force at a coupler end of the electromechanical system, based on the operational data, using a misalignment force model. Further, a vibration simulation model is configured based on the dynamic misalignment force at the coupler-end. The configured vibration simulation model is executed in a simulation environment to estimate the vibration level.

Advantageously, the present invention uses current spectrum through a physics-based approach by making using of physics-based models for vibration simulations and electromagnetic simulations. Consequently, factors such as airgap eccentricity, bearing stiffness etc. may be factored in while generating the current spectrum. In particular, the vibration simulations help in simulating both static and dynamic eccentricity of rotor with respect to a stator of the electromechanical system, based on displacement of the rotor. In other words, eccentricity is directly correlated with displacements of the rotor. Furthermore, errors that may occur from sensor-based vibration measurements is eliminated by using vibration simulations. The airgap eccentricity thus determined is used to simulate the electromagnetic behavior of the electromechanical system.

The method further comprises determining a root cause associated with at least one fault indicated by the current spectrum based on the analysis. The term 'fault' as used herein refers to an anomaly that may eventually lead to failure of the electromechanical system. According to the invention, the step of determining the root cause comprises identifying the at least one fault based on the parameter relevancies determined by the explanation model. Further, the root cause of the at least one fault is determined based on predefined rules. The method further comprises outputting a notification indicating the root cause on an output device.

Advantageously, the use of the xAI system for analyzing the current spectrum enables an end-user to identify and rectify faults easily.

Disclosed herein is also an apparatus for monitoring condition of an electromechanical system. The apparatus comprises one or more processing units and a memory unit communicatively coupled to the one or more processing units. The memory unit comprises a condition monitoring module stored in the form of machine-readable instructions executable by the one or more processing units. The condition monitoring module is configured to perform method steps according to any of the method steps described above.

Disclosed herein is also a system for monitoring condition of an electromechanical system. The system comprises at least one source configured to provide operational data associated with the electromechanical system and an apparatus as described above, communicatively coupled to the at least one source. The apparatus is configured to monitor faults in the electromechanical system according to any of the method steps described above.

Disclosed herein is also a computer-readable medium, on which program code sections of a computer program are saved, the program code sections being loadable into and/or executable by a processor which performs the method as described above when the program code sections are executed.

The realization of the invention by a computer program product and/or a non-transitory computer-readable storage medium has the advantage that computer systems can be easily adopted by installing computer program in order to work as proposed by the present invention.

The computer program product can be, for example, a computer program or comprise another element apart from the computer program. This other element can be hardware, for example a memory device, on which the computer program is stored, a hardware key for using the computer program and the like, and/or software, for example a documentation or a software key for using the computer program.

The above-mentioned attributes, features, and advantages of the present invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:

FIG 1A illustrates a block diagram of a system for monitoring condition of an electromechanical system, in accordance with an embodiment of the present invention;

FIG 1B illustrates a block diagram of an apparatus for monitoring condition of an induction motor, in accordance with an embodiment of the present invention;

FIG 2 shows an exemplary method for generating a current spectrum through simulations, in accordance with an embodiment of the present invention;

FIG 3 shows an example of a current spectrum;

FIG 4 shows a method of monitoring condition of the induction motor, in accordance with an embodiment of the present invention;

FIG 5 illustrates an xAI system, in accordance with an exemplary embodiment of the present invention; and

FIG 6 shows an exemplary method for training an xAI system, in accordance with an embodiment of the present invention; and

FIG 7 shows an exemplary workflow for monitoring condition of an induction motor, in accordance with an embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

FIG 1A illustrates a system 100 for monitoring condition of an electromechanical system 105, in accordance with an embodiment of the present invention. The term 'electromechanical system' as used herein may refer to any rotating electromechanical equipment that operates on the principle of electromagnetic induction. Non-limiting examples of the electromechanical system 105 include AC generators, DC generators, AC motors, DC motors, permanent magnet machines, induction machines and brushed machines. For ease of explanation, the present disclosure is described henceforth by considering the electromechanical system 105 as an induction motor (hereinafter referred to as induction motor 105). It must be understood that the aspects of the invention described with reference to an induction motor may be extended to other types of electromechanical systems.

Non-limiting examples of the induction motor 105 include single phase induction motors such as split phase induction motor, capacitor start induction motor, capacitor start and capacitor run induction motor and shaded pole induction motor, and three phase induction motors such as squirrel cage induction motor and slip ring induction motor. The induction motor 105 comprises a stator, a rotor attached to a shaft and a casing outside the stator. The stator includes windings which when energised causes the rotor to rotate due to the principle of electromagnetic induction.

The system 100 includes an apparatus 110 for monitoring condition of the induction motor 105 based on operational data associated with the induction motor 105. The apparatus 110 receives the operational data from at least one source 115 communicatively coupled to the apparatus 110 over a network 120. The source 115 may include for example, sensing units as well as electronic devices that allow users to manually provide the operational data. In a preferred embodiment, the source 115 is a digital twin that provides real-time operational data of the induction motor 105.Consequently, the source 115 may provide the data in real-time via sensing units or offline as user inputs. The sensing units may be configured to measure at least one of the rotational speed of the rotor, line currents or winding currents, line voltage, line power etc. Similarly, load of the induction motor 105 may be computed in real-time based on current or power measured using the sensing units. The electronic device may include personal computers, workstations, personal digital assistances, tablets etc. The apparatus 110 is further coupled to an output device 125. The output device 125 may include any electronic device configured to display a notification indicating the condition of the induction motor 105.

The apparatus 110 comprises a processing unit 130, a memory 135, a storage unit 140, a communication module 145, a network interface 150, an input unit 155, an output unit 160, a standard interface or bus 165 as shown in FIG 1B. The apparatus 110 can be a (personal) computer, a workstation, a virtual machine running on host hardware, a microcontroller, or an integrated circuit. As an alternative, the apparatus 110 can be a real or a virtual group of computers (the technical term for a real group of computers is "cluster", the technical term for a virtual group of computers is "cloud").

The term 'processing unit', as used herein, means any type of computational circuit, such as, but not limited to, a microprocessor, a microcontroller, a complex instruction set computing microprocessor, a reduced instruction set computing microprocessor, a very long instruction word microprocessor, an explicitly parallel instruction computing microprocessor, a graphics processor, a digital signal processor, or any other type of processing circuit. The processing unit 130 may also include embedded controllers, such as generic or programmable logic devices or arrays, application specific integrated circuits, single-chip computers, and the like. In general, the processing unit 130 may comprise hardware elements and software elements. The processing unit 130 can be configured for multithreading, i.e., the processing unit 130 may host different calculation processes at the same time, executing the either in parallel or switching between active and passive calculation processes.

The memory 135 may include one or more of a volatile memory and a non-volatile memory. The memory 135 may be coupled for communication with the processing unit 130. The processing unit 130 may execute instructions and/or code stored in the memory 135. A variety of computer-readable storage media may be stored in and accessed from the memory 135. The memory 135 may include any suitable elements for storing data and machine-readable instructions, such as read only memory, random access memory, erasable programmable read only memory, electrically erasable programmable read only memory, hard drive, removable media drive for handling compact disks, digital video disks, diskettes, magnetic tape cartridges, memory cards, and the like.

The memory 135 comprises a condition monitoring module 170 stored in the memory 135 in the form of machine-readable instructions and executable by the processing unit 130. These machine-readable instructions when executed causes the processing unit 130 to monitor a condition of the induction motor 105.

The condition monitoring module 170 comprises at least a preprocessing module 172, a simulation module 174, an analysis module 176 and a notification module 178. The preprocessing module 172 is configured to preprocess operational data associated with the induction motor 105, received in real-time. The simulation module 174 is configured to perform at vibration simulations and electromagnetic simulations based on the operational data, to generate a simulated current spectrum of the induction motor 105. The analysis module 176 is configured to analyze the current spectrum using an xAI system. The analysis module 176 is further configured to determine root cause of at least one fault indicated by the current spectrum, based on the analysis of the current spectrum. The notification module 178 is configured to generate a notification indicating the root cause on the output device 125.

The storage unit 140 comprises a non-volatile memory which stores data required for training, testing or validating the xAI system. The storage unit 140 may further comprise a database 180 storing lookup tables or predefined rules for relating parameter relevancies to faults and/or root causes of the faults, maintenance activities to be recommended for specific root causes etc. The input unit 155 may include input means such as keypad, touch-sensitive display, camera, etc. capable of receiving input signal. The output unit 160 may include output means such as displays. The bus 165 acts as interconnect between the processing unit 130, the memory 135, the storage unit 140, and the network interface 150.

The communication module 145 enables the apparatus 110 to communicate with the output device 125. The communication module 145 may support different standard communication protocols such as Transport Control Protocol/Internet Protocol (TCP/IP), Profinet, Profibus, and Internet Protocol Version (IPv).

According to an embodiment of the present invention, the apparatus 110 can be an edge computing device. As used herein "edge computing" refers to computing environment that is capable of being performed on an edge device (e.g., connected to sensing units in an industrial setup and one end and to a remote server(s) such as for computing server(s) or cloud computing server(s) on other end), which may be a compact computing device that has a small form factor and resource constraints in terms of computing power. A network of the edge computing devices can also be used to implement the apparatus 110. Such a network of edge computing devices is referred to as a fog network.

In another embodiment, the apparatus 110 is a cloud computing system having a cloud computing based platform configured to provide a cloud service for monitoring condition of an induction motor 105. As used herein, "cloud computing" refers to a processing environment comprising configurable computing physical and logical resources, for example, networks, servers, storage, applications, services, etc., and data distributed over the network 120, for example, the internet. The cloud computing platform may be implemented as a service for monitoring condition of an induction motor 105. In other words, the cloud computing system provides on-demand network access to a shared pool of the configurable computing physical and logical resources. The network 120 is, for example, a wired network, a wireless network, a communication network, or a network formed from any combination of these networks.

Those of ordinary skilled in the art will appreciate that the hardware depicted in FIGs 1A and 1B may vary for different implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter, network connectivity devices also may be used in addition or in place of the hardware depicted. The depicted example is provided for the purpose of explanation only and is not meant to imply architectural limitations with respect to the present disclosure.

FIG 2 shows an exemplary method 200 for generating a current spectrum through simulations, in accordance with an embodiment of the present invention.

At step 205, a dynamic misalignment force corresponding to a misalignment error in the induction motor 105 is determined using a misalignment force model. In an embodiment, the misalignment error is computed using a digital twin of the induction motor 105. For example, the digital twin may compute the misalignment error based on operational data associated with the induction motor 105. The misalignment force model is a predetermined mathematical model that helps in calculating dynamic load or the dynamic misalignment force, at a coupler end of the induction motor 105, based on the misalignment error. In an example, the dynamic misalignment force may be correlated with one or more characteristics of the induction motor 105. The characteristics may include, for example, a stiffness of the drive-end bearing. Alternatively, the stiffness may also be computed based on bearing specifications such as size and type of the bearing.

At step 210, the dynamic misalignment force along with the characteristics are further used to simulate vibration of the induction motor 105. The vibration is simulated by configuring a vibration simulation model based on the dynamic misalignment force and the characteristics associated with the induction motor 105. Upon simulation, a time-domain signal corresponding to vibration level at the rotor's surface is generated. As may be understood by a person skilled in the art, the vibration level indicates an eccentricity within the airgap of the induction motor.

At step 215, the time-domain signal is further provided as input to an electromagnetic simulation model, in addition to load and rotational speed associated with the induction motor 105. The electromagnetic simulation model is an equivalent circuit of the induction motor 105 configured based on a three-dimensional Computer-Aided Design (CAD) model of the induction motor 105. The CAD model includes information corresponding to, for example, number of rotor bars, number of stator slots, geometric specifications, material properties, bearings specifications and shaft specifications associated with the induction motor 105.

The electromagnetic simulation model is further executed in a simulation environment to simulate changes in airgap flux due to the misalignment. Based on execution of the electromagnetic simulation model, a current signature of the rotor resulting from the magnetic flux variations in the airgap of the induction motor is computed. The current signature is a time-domain data associated with the misalignment.

At step 220, Fast Fourier Transform (FFT) is used to generate the current spectrum from the current signature. The current spectrum indicates fundamental frequency components of the current signature and harmonics resulting from air-gap eccentricity due to the misalignment. The current spectrum indicates at least one characteristic feature associated with the misalignment.

The frequency components, $f_{ec}$, due to eccentricity in Hz is identified using the following equation:

$$f_{ec} = f_1\left(Rs\frac{1-s}{p} \pm \eta_{ws}\right) + f_1\left(\frac{1-s}{p}\right) \quad (1)$$

where $f_1\left(Rs\frac{1-s}{p} \pm \eta_{ws}\right)$ is the rotor slot frequency and $f_1\left(\frac{1-s}{p}\right)$ rotor running frequency.

Here, $f_1$ indicates supply frequency in Hz;

Rs is number of rotor bars;
$\eta_{ws}$ is 1, 2, 3 etc., where integer 1 corresponds to fundamental component, integer 2 corresponds to second harmonics, integer 3 corresponds to third harmonics and so on;
s is rotor per unit slip; and
p is number of pole-pairs.

FIG 3 shows a Graphical User Interface 300 displaying an example of a current spectrum generated based on equation (1). The current spectrum includes three spectral lines: a main component of 80 dB at 2.8 kHz and two sidebands of 44 dB and 40 dB at (2792.4 - 59.4) Hz and (2792.4 + 59.4) Hz respectively.

Similarly, misalignment at lower frequencies is detected using the following equation:

$$f_e = f_1 + mf_r \quad (2)$$

Here, $f_1$ is the supply frequency;

$f_r$ is the rotational speed frequency of the rotor;
$m$ is the harmonic number (1, 2, 3..)
$f_e$ is the current component frequency due to airgap changes.

FIG 4 shows a method 400 of monitoring condition of the induction motor 105, in accordance with an embodiment of the present invention. The condition of the induction motor 105 is monitored based on a set of parameters received from the at least one source 115. The parameters include rotational speed, load and spectral features associated with a current spectrum of the induction motor 105. The spectral features may be obtained from at least one of a simulated current spectrum and a field current spectrum. The spectral features include, but are not limited to, amplitudes, spectral lines, sidebands and frequencies (e.g. principal rotor bar pass frequency (PRBPF)) associated with the spectral lines. The simulated current spectrum is generated via simulations based on the load and rotational speed. The field current spectrum is obtained by processing an electrical signal associated with the induction motor 105. In a preferred embodiment, the spectral features are obtained from both the simulated current spectrum and the field current spectrum.

At step 405, the set of parameters associated with the induction motor 105 is analyzed using an xAI system. FIG 5 illustrates an xAI system 500, in accordance with an exemplary embodiment of the present invention. The xAI system 500 receives a set of parameters 505 as input. The xAI system 500 comprises a prediction model 510 and an explanation model 515.

In the present embodiment, the prediction model 510 is a temporal convolutional network, trained using Adam optimizer, for optimizing cross-entropy loss. The prediction model 510 computes a misalignment probability based on the set of parameters 505, the rotational speed and the load associated with the induction motor 105. In an embodiment, the set of parameters may include load, rotational speed and spectral features associated with the current spectrum. In an example, the misalignment probability may have a value between 0 to 100%. The prediction model 510 calculates a total probability distribution, i.e., the misalignment probability based on the parameters.

The explanation model 515 may be based on deep Taylor decomposition. In an embodiment, the explanation model 515 may include a deep neural network model that uses backpropagation to examine activation differences between artificial neurons in various layers of the deep neural network. Layer-wise Relevance Propagation technique decomposes an 'explanation' into local updates by recursively defining the contribution to relevance for all neurons in a previous layer. This method requires a fixed number of forward-prediction and backward-gradient passes to compute the attribution. The explanation model 515 further decomposes or distributes the misalignment probability based on the parameters over discrete time-steps based on Layer-wise Relevance Propagation (LRP) technique. The technique employs the following equation for decomposing the misalignment probability based on the parameters:

$$p_\theta(x) = \prod_{t=1}^{T} p_\theta(x_t | x_{1:t-1}) \qquad (3)$$

**where** $x = \{x_1, x_2, \ldots, x_T\}$ is a sequence.

In other words, the explanation model 515 generates physics-based explanations 520 corresponding to each of the parameters, from the misalignment probability computed by the prediction model 510. The explanations 520 include parameter relevancies corresponding to each of the parameters. The term 'parameter relevancy' of a parameter may be defined as a numerical value indicating a degree of impact the parameter may have on the misalignment. In the present example, the parameter relevancies corresponding to each parameter is indicated using lines of varying thicknesses. The thickness of the line is directly proportional to the parameter relevancy.

In an embodiment, key performance indicators (KPIs) based on sideband magnitudes are further used for estimating eccentricity due to misalignment of the rotor. In an example, the KPI is an average of the sidebands in the current spectrum. For example, if the central component at central frequency f (Hz) is of amplitude A1 (dB) and the sidebands at sideband frequencies $f\text{-}f_s$ and $f\text{+}f_s$ are of amplitude A2 and A3 respectively, a first KPI, KPI1 (or A4) may be defined as:

$$A4 = (A2+A3)/2 \qquad (3)$$

Similarly, a second KPI, KPI2 may be defined as:

$$KPI2 = A1 - A4 \qquad (4)$$

Table 1 illustrates sample of simulation results for KPI1 for different values of static and dynamic eccentricity.

**Table 1: Side band average (KPI1)**

| Hz | No eccentricity | 30% Static Eccentricity | 50% Static Eccentricity | 30% Dynamic Eccentricity | 50% Dynamic Eccentricity |
|---|---|---|---|---|---|
| 50 | 0.050378319 | 0.537438109 | 0.544626697 | 0.537469569 | 0.544855576 |
| 325 | 0.009011253 | 0.040031981 | 0.037705729 | 0.040709734 | 0.039807435 |
| 425 | 0.021595386 | 0.031257541 | 0.031620004 | 0.031195086 | 0.031497022 |
| 525 | 0.023958906 | 0.041759721 | 0.042526812 | 0.041452604 | 0.041638849 |
| 625 | 0.057848073 | 0.088194122 | 0.089262558 | 0.087846466 | 0.088283284 |
| 725 | 0.127519367 | 0.173739847 | 0.175968649 | 0.173793063 | 0.176199573 |
| 825 | 0.043311988 | 0.087094463 | 0.087976404 | 0.087086508 | 0.088054387 |
| 925 | 0.025306449 | 0.04621612 | 0.04772191 | 0.046221583 | 0.047808126 |
| 1025 | 0.033391947 | 0.022993602 | 0.023194372 | 0.023061268 | 0.023820036 |

From the simulation results in Table 1, it may be understood that the KPI1 has a strong correlation with eccentricity at frequencies 50 Hz, 425 Hz, 525 Hz, 625 Hz, 725 Hz, 825 Hz and 925 Hz, weak correlation for eccentricity at 325 Hz and no correlation with eccentricity at 1025 Hz.

Table 2 illustrates simulation results for KPI2 for different values of static and dynamic eccentricity.

**Table 2: Central frequency average (KPI2)**

| Hz | No eccentricity | 30% Static Eccentricity | 50% Static Eccentricity | 30% Dynamic Eccentricity | 50% Dynamic Eccentricity |
|---|---|---|---|---|---|
| 50 | 7.635928443 | 6.57655817 | 6.562735931 | 6.578497043 | 6.567735373 |
| 325 | 0.039881514 | 0.020002076 | 0.021603574 | 0.018626163 | 0.017690114 |
| 425 | 0.034050134 | -0.01203245 | -0.01205597 | -0.01298268 | -0.01369106 |
| 525 | 0.026045827 | 0.004489709 | -0.00548111 | 0.006463993 | 0.000386958 |
| 625 | 0.60988102 | 0.521769802 | 0.526013198 | 0.520860365 | 0.523609167 |
| 725 | 1.923933954 | 1.852458996 | 1.861897013 | 1.848513591 | 1.85070036 |
| 825 | 0.490756056 | 0.411166936 | 0.415445873 | 0.410833356 | 0.414122706 |
| 925 | 0.127672723 | 0.099056571 | 0.096466678 | 0.099279549 | 0.09734243 |
| 1025 | 0.016655911 | 0.048461351 | 0.050211327 | 0.048762846 | 0.050518831 |

From the simulation results in Table 2, it may be understood that the KPI2 has a strong correlation with eccentricity at frequencies 50 Hz, 425 Hz, 525 Hz and 925 Hz, weak correlation for eccentricity at 325 Hz, 625 Hz, 725 Hz, 825 Hz and no correlation with eccentricity at 1025 Hz.

Based on the KPIs, the explanation model generates the explanation. For example, if the average of side band magnitude is greater than 40 dB, the explanation 520 is indicative of an airgap eccentricity within 5% of radial airgap. If average of side band magnitudes is between 35-40 dB, the explanation 520 is indicative of an airgap eccentricity within 10% of radial airgap. If average of side band magnitudes is between 25-35 dB, the explanation 520 is indicative of an airgap eccentricity within 10% of radial airgap, but around 15% of radial airgap near 25 dB. If average of side band magnitudes is between 15-25 dB, the explanation 520 is indicative of an airgap eccentricity greater than 15% of radial airgap, but around 20% of radial airgap near 15 dB. If average of side band magnitudes is greater than 15 dB, the explanation 520 is indicative of an airgap eccentricity greater than 20% of radial airgap.

At step 410, a root cause associated with at least one fault indicated by the current spectrum is determined based on the analysis. The root causes may be predetermined corresponding to the parameter relevancies. For example, the root causes may be identified based on predefined rules from the significance of parameters in the parameter relevancies. For example, the root cause may indicate mechanical failure of parts such as bearings, manufacturing defects, etc. If the parameter relevancy corresponding to rotational speed is highest, then a mechanical failure, e.g. bearing failure, may be identified. Similarly, if the parameter relevancy corresponding to load is high, an electrical failure may be identified.

At step 415, a notification indicating the root cause is outputted on the output device 125. For example, the notification may include a representation of parameter relevancies associated with each of the parameters. Further, the root cause may be displayed alongside the parameter relevancies in the form of a text notification. For example, the text notification may be of the form 'Drive-end bearing failure identified'.

FIG 6 illustrates a method 600 for training an xAI system, in accordance with an exemplary embodiment of the present disclosure.

At step 605, training data corresponding to different operating conditions and misalignment errors in an induction motor 105 are obtained from a source. For example, the source may be an electronic device that provides access to a data repository. The training data comprises a plurality of datasets, each dataset comprising a rotational speed, load and a misalignment error associated with the induction motor 105.

At step 610, a simulated current spectrum is generated from the misalignment error, as explained earlier using method 200.

At step 615, spectral features associated with the simulated current spectrum along with the corresponding load and rotational speed are used for training the prediction model 510 and the explainable model 515 in the xAI system 505. Upon training, the xAI system 500 may be tested based on a test current spectrum. The test current spectrum may be derived based on a measured rotor current of the induction motor 105. Upon testing, errors in prediction of parameter relevancies may be reduced by training the xAI system 500 using a different training set.

FIG 7 illustrates an exemplary workflow 700 for monitoring condition of an induction motor, in accordance with an embodiment of the present invention. The workflow begins at step 705, when a misalignment in a rotor of the induction motor is detected. Further, a misalignment error associated with the misalignment is determined. At step 710, the misalignment error used to compute a dynamic misalignment force at a coupler-end using a misalignment force model. Further, the dynamic misalignment force may also be used to dynamically calibrate a stiffness of the drive-end bearing of the induction motor based on a correlation between stiffness and dynamic misalignment force, as shown at step 715.

Based on the dynamic misalignment force and the stiffness of the drive-end bearing, a vibration simulation is performed at step 720. Based on the vibration levels, i.e. displacement of the rotor due to the vibrations, an electromagnetic simulation is performed, at step 725. Similarly, a correlation between the displacement and a velocity associated with the vibration may also be generated from the vibration simulation, at step 730. Based on the electromagnetic simulation, a current spectrum of the induction motor is generated at step 735. The simulated current spectrum from step 735 along with a field/test current spectrum 740 and the velocity and displacement data from step 730 are correlated at step 745. The correlation may be performed using known correlation analysis techniques. Based on the correlation, a set of spectral features is generated. The spectral features along with the load and the rotational speed of the induction motor are provided as inputs to an xAI system (similar to xAI system 500) at step 750. Further, parameter relevancies generated by the xAI system based on the inputs are used for analysing a root cause associated with the misalignment at step 755.

Advantageously, the present invention helps in determining contribution of various factors towards misalignment in an induction motor, in terms of relevance. As a result, identification of root cause associated with the misalignment is easier. Therefore, the time required for identifying issues leading to misalignment may be reduced compared to manual inspection.

The present invention is not limited to a particular computer system platform, processing unit, operating system, or network. One or more aspects of the present invention may be distributed among one or more computer systems, for example, servers configured to provide one or more services to one or more client computers, or to perform a complete task in a distributed system. For example, one or more aspects of the present invention may be performed on a client-server system that comprises components distributed among one or more server systems that perform multiple functions according to various embodiments. These components comprise, for example, executable, intermediate, or interpreted code, which communicate over a network using a communication protocol. The present invention is not limited to be executable on any particular system or group of system, and is not limited to any particular distributed architecture, network, or communication protocol.

<u>List of reference numerals</u>

100 system for monitoring condition of an electromechanical system
105 electromechanical system
110 apparatus for monitoring condition of an electromechanical system
115 source
120 network
125 output device
130 processing unit
135 memory
140 storage unit
145 communication module
150 network interface
155 input unit
160 output unit
165 standard interface or bus
170 condition monitoring module
172 preprocessing module
174 simulation module
176 analysis module
178 notification module
180 database
300 Graphical User Interface displaying an example of a current spectrum
500 xAI system
505 set of parameters
510 prediction model
515 explanation model
520 explanations

## Claims

1. A computer-implemented method for monitoring condition of an electromechanical system (105), wherein the electronical system (105) is an induction motor, and wherein the method comprises:

   receiving operational data from a sensing unit, wherein the sensing unit is configured to measure at least one of the rotational speed of a rotor, line currents or winding currents, line voltage, line power, and wherein the operational data comprise at least one parameter of a set of parameters associated with the electronical system (105);
   generating a current spectrum of the electromechanical system (105), through at least one simulation of the electromechanical system (105), wherein generating the current spectrum of the electromechanical system (105) through the at least one simulation comprises:

      determining a vibration level of the rotor of the electromechanical system (105) based on the operational data associated with the electromechanical system (105);
      configuring an electromagnetic simulation model based on the vibration level; and
      executing the electromagnetic simulation model in a simulation environment to determine changes in a magnetic flux distribution within the electromechanical system (105); and
      generating the current spectrum based on the changes in the magnetic flux distribution;

   analyzing, by a processing unit (130), the set of parameters associated with the electromechanical system (105) using an Explainable Artificial Intelligence (xAI) system (500), wherein the set of parameters include at least a load, a rotational speed and one or more spectral features associated with the current spectrum of the electromechanical system (105), wherein the spectral features include, amplitudes, spectral lines, sidebands and frequencies associated with the spectral lines, wherein the xAI system (500) comprises a prediction model and an explanation model, and wherein analyzing the set of parameters associated with the electromechanical system (105) using the xAI system (500) comprises:

      determining a misalignment probability based on the set of parameters using the prediction model;
      determining parameter relevancies corresponding to each of the parameters, based on the misalignment probability, using the explanation model, wherein the parameter relevancies are defined as a numerical value indicating a degree of impact the parameter has on the misalignment;

   determining a root cause associated with at least one fault indicated by the current spectrum based on the analysis, wherein determining a root cause associated with the at least one fault based on the analysis, comprises:

      identifying the at least one fault based on the parameter relevancies determined by the explanation model; and
      determining the root cause of the at least one fault based on predefined rules; and
      outputting a notification indicating the root cause on an output device (125).

2. The method according to claim 1, wherein the prediction model is a temporal convolutional network.

3. The method according to claim 1 or 2, wherein the explanation model is a deep neural network based on Layer-wise Relevance Propagation algorithm.

4. The method according to any of the previous claims, wherein determining the vibration level of the rotor associated with the electromechanical system (105) based on the operational data comprises:

   estimating a dynamic misalignment force at a coupler end of the electromechanical system (105), based on the operational data, using a misalignment force model;
   configuring a vibration simulation model based on the dynamic misalignment force at the coupler-end; and
   executing the configured vibration simulation model in the simulation environment to estimate the vibration level.

5. An apparatus (110) for monitoring condition of an electromechanical system (105), the apparatus (110) comprising:

   one or more processing units (130); and

a memory unit (135) communicatively coupled to the one or more processing units (130), wherein the memory unit (135) comprises a condition monitoring module (170) stored in the form of machine-readable instructions executable by the one or more processing units (130), wherein the condition monitoring module (170) is configured to perform method steps for monitoring the condition of the electromechanical system (105), according to any of the claims 1 to 4.

**6.** A system (100) for monitoring eccentricity in an electromechanical system (105), the system (100) comprising:

at least one source (115) configured to provide operational data associated with the electromechanical system (105);
an apparatus (110) according to claim 5, communicatively coupled to the at least one source, wherein the apparatus (110) is configured to monitor condition of the electromechanical system (105) according to any of the method claims 1 to 4.

**7.** A computer-program product having machine-readable instructions stored therein, which when executed by one or more processing units (130), cause the processing units (130) to perform a method according to any of the claims 1 to 4.

## Patentansprüche

**1.** Computerimplementiertes Verfahren zum Überwachen eines Zustands eines elektromechanischen Systems (105), wobei das elektronische System (105) ein Induktionsmotor ist, und wobei das Verfahren Folgendes umfasst:

Empfangen von Betriebsdaten von einer Erfassungseinheit, wobei die Erfassungseinheit dazu konfiguriert ist, mindestens eines von der Drehzahl eines Rotors, Leitungsströmen oder Wicklungsströmen, Leitungsspannung, Leitungsleistung zu messen, und wobei die Betriebsdaten mindestens einen Parameter eines Satzes von Parametern in Zusammenhang mit dem elektronischen System (105) umfassen;
Erzeugen eines Stromspektrums des elektromechanischen Systems (105) durch mindestens eine Simulation des elektromechanischen Systems (105), wobei das Erzeugen des Stromspektrums des elektromechanischen Systems (105) durch die mindestens eine Simulation Folgendes umfasst:

Bestimmen eines Vibrationspegels des Rotors des elektromechanischen Systems (105) basierend auf den Betriebsdaten in Zusammenhang mit dem elektromechanischen System (105);
Konfigurieren eines elektromagnetischen Simulationsmodells basierend auf dem Vibrationspegel; und
Ausführen des elektromagnetischen Simulationsmodells in einer Simulationsumgebung, um Änderungen einer Magnetflussverteilung innerhalb des elektromechanischen Systems (105) zu bestimmen; und
Erzeugen des Stromspektrums basierend auf den Änderungen der Magnetflussverteilung;
Analysieren, durch eine Verarbeitungseinheit (130), des Satzes von Parametern in Zusammenhang mit dem elektromechanischen System (105) unter Verwendung eines Erklärbare-Künstliche-Intelligenz(xAI)-Systems (500), wobei der Satz von Parametern mindestens eine Last, eine Drehzahl und ein oder mehrere spektrale Merkmale in Zusammenhang mit dem Stromspektrum des elektromechanischen Systems (105) beinhaltet, wobei die spektralen Merkmale Amplituden, Spektrallinien, Seitenbänder und Frequenzen in Zusammenhang mit den Spektrallinien beinhalten, wobei das xAI-System (500) ein Vorhersagemodell und ein Erklärungsmodell umfasst, und wobei das Analysieren des Satzes von Parametern in Zusammenhang mit dem elektromechanischen System (105) unter Verwendung des xAI-Systems (500) Folgendes umfasst:

Bestimmen einer Fehlausrichtungswahrscheinlichkeit basierend auf dem Satz von Parametern unter Verwendung des Vorhersagemodells;
Bestimmen von Parameterrelevanzen, die jedem der Parameter entsprechen, basierend auf der Fehlausrichtungswahrscheinlichkeit unter Verwendung des Erklärungsmodells, wobei die Parameterrelevanzen als ein numerischer Wert definiert sind, der einen Grad einer Auswirkung angibt, die der Parameter auf die Fehlausrichtung hat;
Bestimmen einer Grundursache in Zusammenhang mit mindestens einem durch das Stromspektrum angezeigten Fehler basierend auf der Analyse, wobei das Bestimmen einer Grundursache in Zusammenhang mit dem mindestens einen Fehler basierend auf der Analyse Folgendes umfasst:

Identifizieren des mindestens einen Fehlers basierend auf den durch das Erklärungsmodell bestimmten Parameterrelevanzen; und
Bestimmen der Grundursache des mindestens einen Fehlers basierend auf vordefinierten Regeln; und
Ausgeben einer Benachrichtigung, die die Grundursache anzeigt, auf einer Ausgabevorrichtung (125).

**2.** Verfahren nach Anspruch 1, wobei das Vorhersagemodell ein temporales Faltungsnetz ist.

**3.** Verfahren nach Anspruch 1 oder 2, wobei das Erklärungsmodell ein tiefes neuronales Netz ist, das auf einem "Layer-wise Relevance Propagation"-Algorithmus basiert.

**4.** Verfahren nach einem der vorhergehenden Ansprüche, wobei das Bestimmen des Vibrationspegels des Rotors in Zusammenhang mit dem elektromechanischen System (105) basierend auf den Betriebsdaten Folgendes umfasst:

Schätzen einer dynamischen Fehlausrichtungskraft an einem Kopplerende des elektromechanischen Systems (105) basierend auf den Betriebsdaten unter Verwendung eines Fehlausrichtungskraftmodells;
Konfigurieren eines Vibrationssimulationsmodells basierend auf der dynamischen Fehlausrichtungskraft an dem Kopplerende; und
Ausführen des konfigurierten Vibrationssimulationsmodells in der Simulationsumgebung, um den Vibrationspegel zu schätzen.

**5.** Einrichtung (110) zum Überwachen eines Zustands eines elektromechanischen Systems (105), wobei die Einrichtung (110) Folgendes umfasst:

eine oder mehrere Verarbeitungseinheiten (130); und
eine Speichereinheit (135), die kommunikativ mit der einen oder den mehreren Verarbeitungseinheiten (130) gekoppelt ist, wobei die Speichereinheit (135) ein Zustandsüberwachungsmodul (170) umfasst, das in Form von maschinenlesbaren Anweisungen gespeichert ist, die durch die eine oder die mehreren Verarbeitungseinheiten (130) ausführbar sind, wobei das Zustandsüberwachungsmodul (170) dazu konfiguriert ist, Verfahrensschritte zum Überwachen des Zustands des elektromechanischen Systems (105) nach einem der Ansprüche 1 bis 4 durchzuführen.

**6.** System (100) zum Überwachen einer Exzentrizität in einem elektromechanischen System (105), wobei das System (100) Folgendes umfasst:

mindestens eine Quelle (115), die dazu konfiguriert ist, Betriebsdaten in Zusammenhang mit dem elektromechanischen System (105) bereitzustellen;
eine Einrichtung (110) nach Anspruch 5, die kommunikativ mit der mindestens einen Quelle gekoppelt ist, wobei die Einrichtung (110) dazu konfiguriert ist, einen Zustand des elektromechanischen Systems (105) nach einem der Verfahrensansprüche 1 bis 4 zu überwachen.

**7.** Computerprogrammprodukt mit darin gespeicherten maschinenlesbaren Anweisungen, die bei Ausführung durch eine oder mehrere Verarbeitungseinheiten (130) die Verarbeitungseinheiten (130) veranlassen, ein Verfahren nach einem der Ansprüche 1 bis 4 durchzuführen.

## Revendications

**1.** Procédé mis en œuvre par ordinateur pour surveiller l'état d'un système électromécanique (105), le système électronique (105) étant un moteur à induction, et le procédé comprenant :

la réception de données opérationnelles en provenance d'une unité de détection, l'unité de détection étant configurée pour mesurer au moins un élément parmi la vitesse de rotation d'un rotor, des courants de ligne et/ou des courants d'enroulement, une tension de ligne, une puissance de ligne, et les données opérationnelles comprenant au moins un paramètre parmi un ensemble de paramètres associés au système électronique (105) ;
la génération d'un spectre actuel du système électromécanique (105), par le biais d'au moins une simulation du système électromécanique (105), la génération du spectre actuel du système électromécanique (105) par le biais de l'au moins une simulation comprenant :

la détermination d'un niveau de vibration du rotor du système électromécanique (105) sur la base des données opérationnelles associées au système électromécanique (105) ;
la configuration d'un modèle de simulation électromagnétique sur la base du niveau de vibration ; et
l'exécution du modèle de simulation électromagnétique dans un environnement de simulation pour déterminer des changements dans une distribution de flux magnétique à l'intérieur du système électromécanique (105) ; et
la génération du spectre actuel sur la base des changements dans la distribution de flux magnétique ;
l'analyse, par une unité de traitement (130), de l'ensemble de paramètres associés au système électromécanique (105) à l'aide d'un système d'intelligence artificielle explicable (xAI) (500), l'ensemble de paramètres incluant au moins une charge, une vitesse de rotation et une ou plusieurs caractéristiques spectrales associées au spectre actuel du système électromécanique (105), les caractéristiques spectrales incluant des amplitudes, des raies spectrales, des bandes latérales et des fréquences associées aux raies spectrales, le système xAI (500) comprenant un modèle de prédiction et un modèle d'explication, et l'analyse de l'ensemble de paramètres associés au système électromécanique (105) à l'aide du système xAI (500) comprenant :

la détermination d'une probabilité de mésalignement sur la base de l'ensemble de paramètres à l'aide du modèle de prédiction ;
la détermination de pertinences de paramètres correspondant à chacun des paramètres, sur la base de la probabilité de mésalignement, à l'aide du modèle d'explication, les pertinences de paramètres étant définies en tant que valeur numérique indiquant un degré d'impact que le paramètre a sur le mésalignement ;
la détermination d'une cause profonde associée à au moins un défaut indiqué par le spectre actuel sur la base de l'analyse, la détermination d'une cause profonde associée à l'au moins un défaut sur la base de l'analyse, comprenant :

l'identification de l'au moins un défaut sur la base des pertinences de paramètres déterminées par le modèle d'explication ; et
la détermination de la cause profonde de l'au moins un défaut sur la base de règles prédéfinies ; et
la sortie d'une notification indiquant la cause profonde sur un dispositif de sortie (125).

**2.** Procédé selon la revendication 1, dans lequel le modèle de prédiction est un réseau convolutif temporel.

**3.** Procédé selon la revendication 1 ou la revendication 2, dans lequel le modèle d'explication est un réseau neuronal profond basé sur un algorithme de propagation de pertinence par couches.

**4.** Procédé selon l'une quelconque des revendications précédentes, dans lequel la détermination du niveau de vibration du rotor associé au système électromécanique (105) sur la base des données opérationnelles comprend :

l'estimation d'une force de mésalignement dynamique au niveau d'une extrémité de coupleur du système électromécanique (105), sur la base des données opérationnelles, à l'aide d'un modèle de force de mésalignement ;
la configuration d'un modèle de simulation de vibration sur la base de la force de mésalignement dynamique au niveau de l'extrémité de coupleur ; et
l'exécution du modèle de simulation de vibration configuré dans l'environnement de simulation pour estimer le niveau de vibration.

**5.** Appareil (110) pour surveiller l'état d'un système électromécanique (105), l'appareil (110) comprenant :

une ou plusieurs unités de traitement (130) ; et
une unité (135) de mémoire couplée en communication à l'unité ou aux unités (130) de traitement, l'unité (135) de mémoire comportant un module (170) de surveillance d'état stocké sous la forme d'instructions lisibles par machine exécutables par l'unité ou les unités (130) de traitement, le module (170) de surveillance d'état étant configuré pour réaliser les étapes de procédé afin de surveiller l'état du système électromécanique (105), selon l'une quelconque des revendications 1 à 4.

**6.** Système (100) pour surveiller l'excentricité d'un système électromécanique (105), le système (100) comprenant :

au moins une source (115) configurée pour fournir des données opérationnelles associées au système électromécanique (105) ;
un appareil (110) selon la revendication 5, couplé en communication à l'au moins une source, l'appareil (110) étant configuré pour surveiller l'état du système électromécanique (105) selon l'une quelconque des revendications de procédé 1 à 4.

**7.** Produit de programme informatique dans lequel sont stockées des instructions lisibles par machine, qui lorsqu'elles sont exécutées par une ou plusieurs unités de traitement (130), amènent les unités de traitement (130) à réaliser un procédé selon l'une quelconque des revendications 1 à 4.

FIG 1A

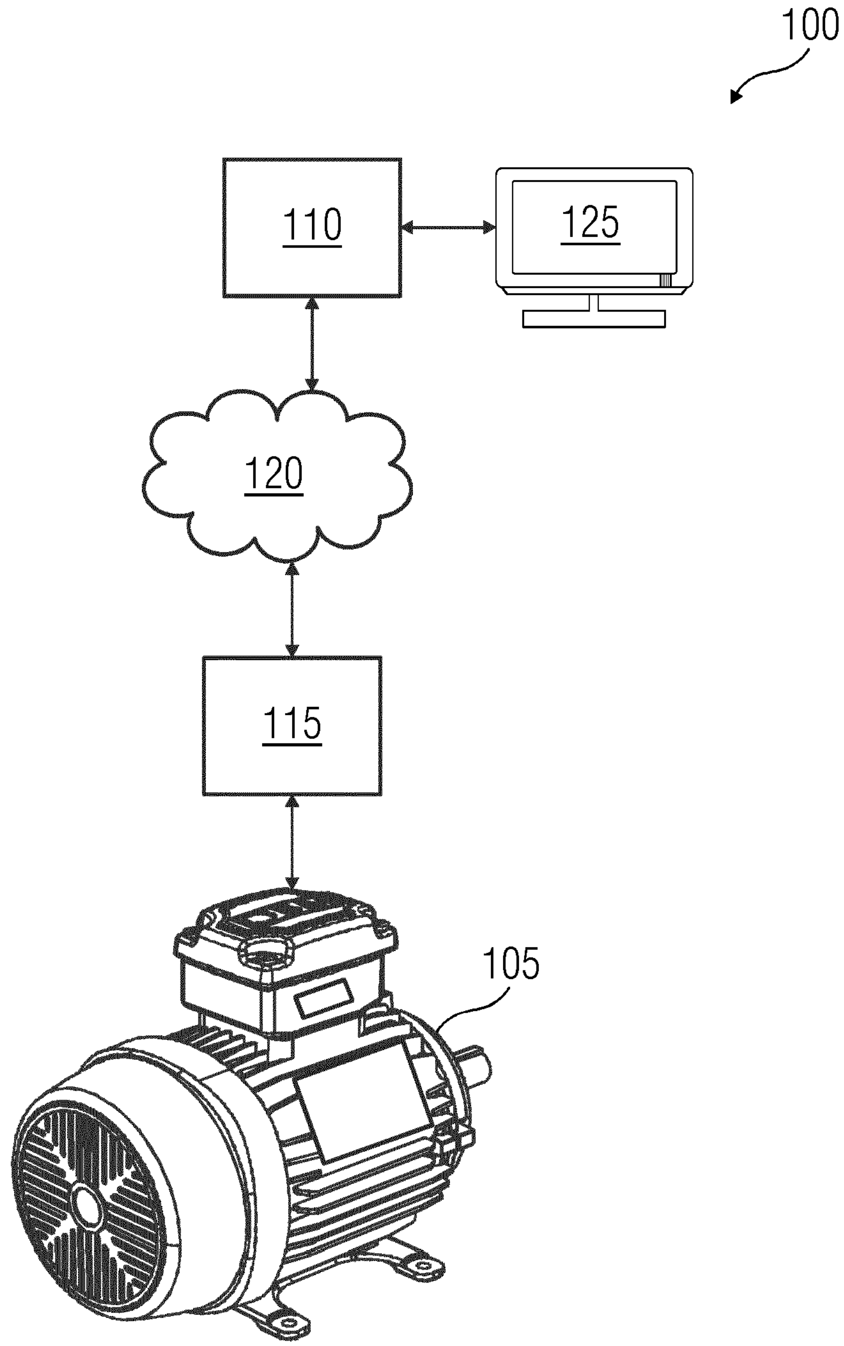

FIG 1B

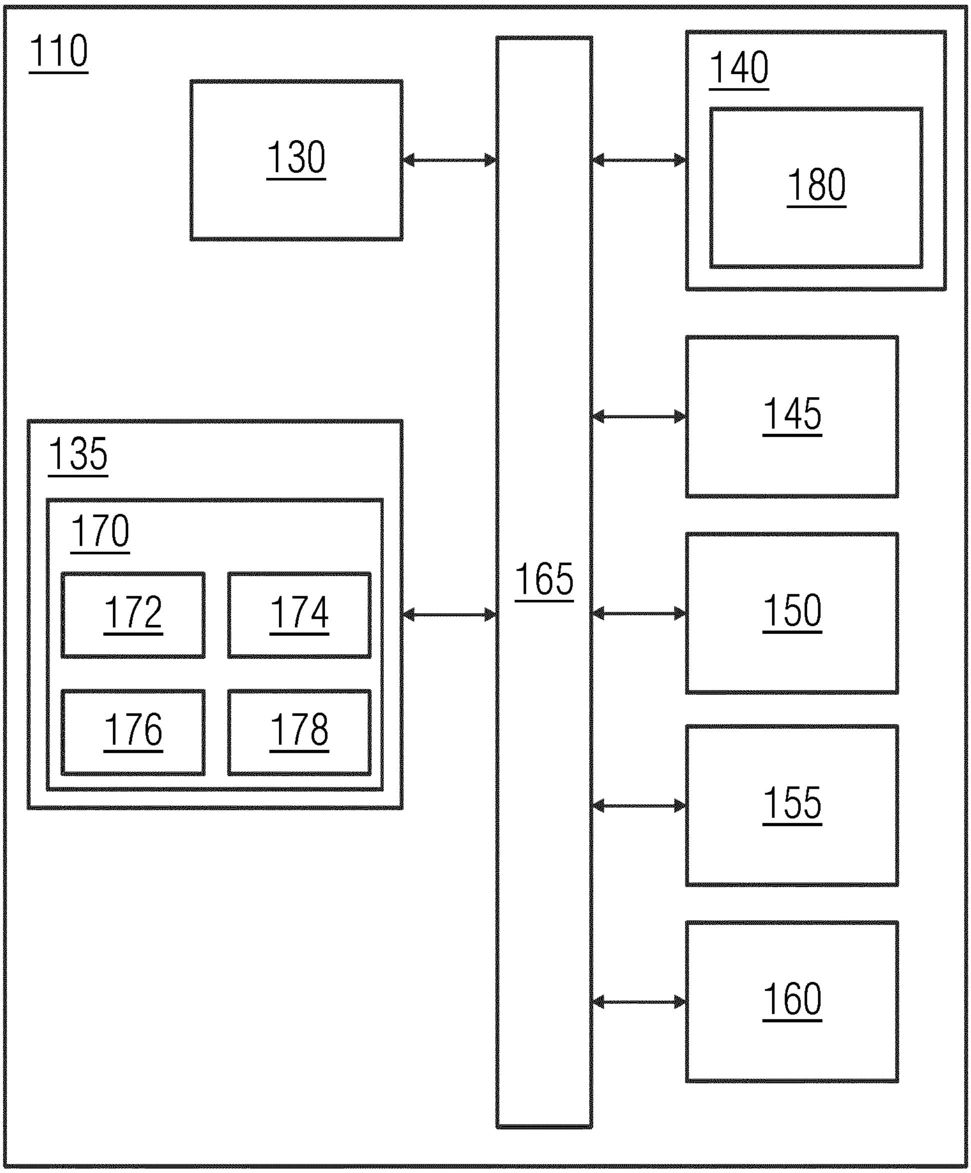

FIG 2

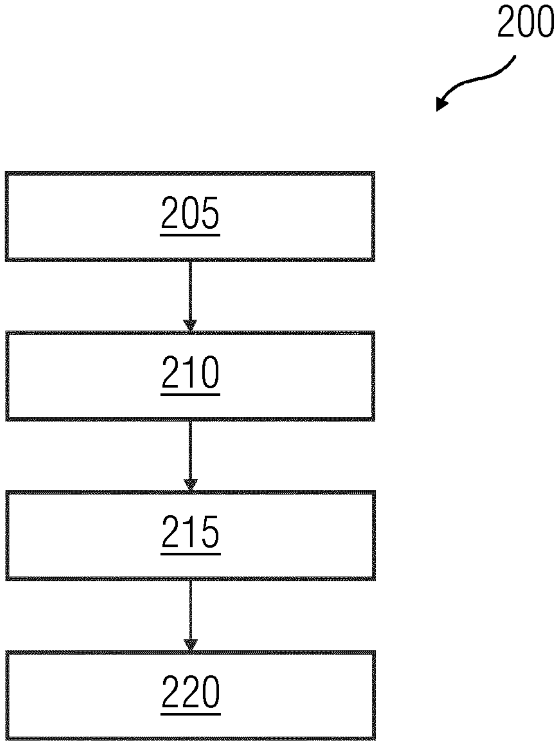

FIG 3

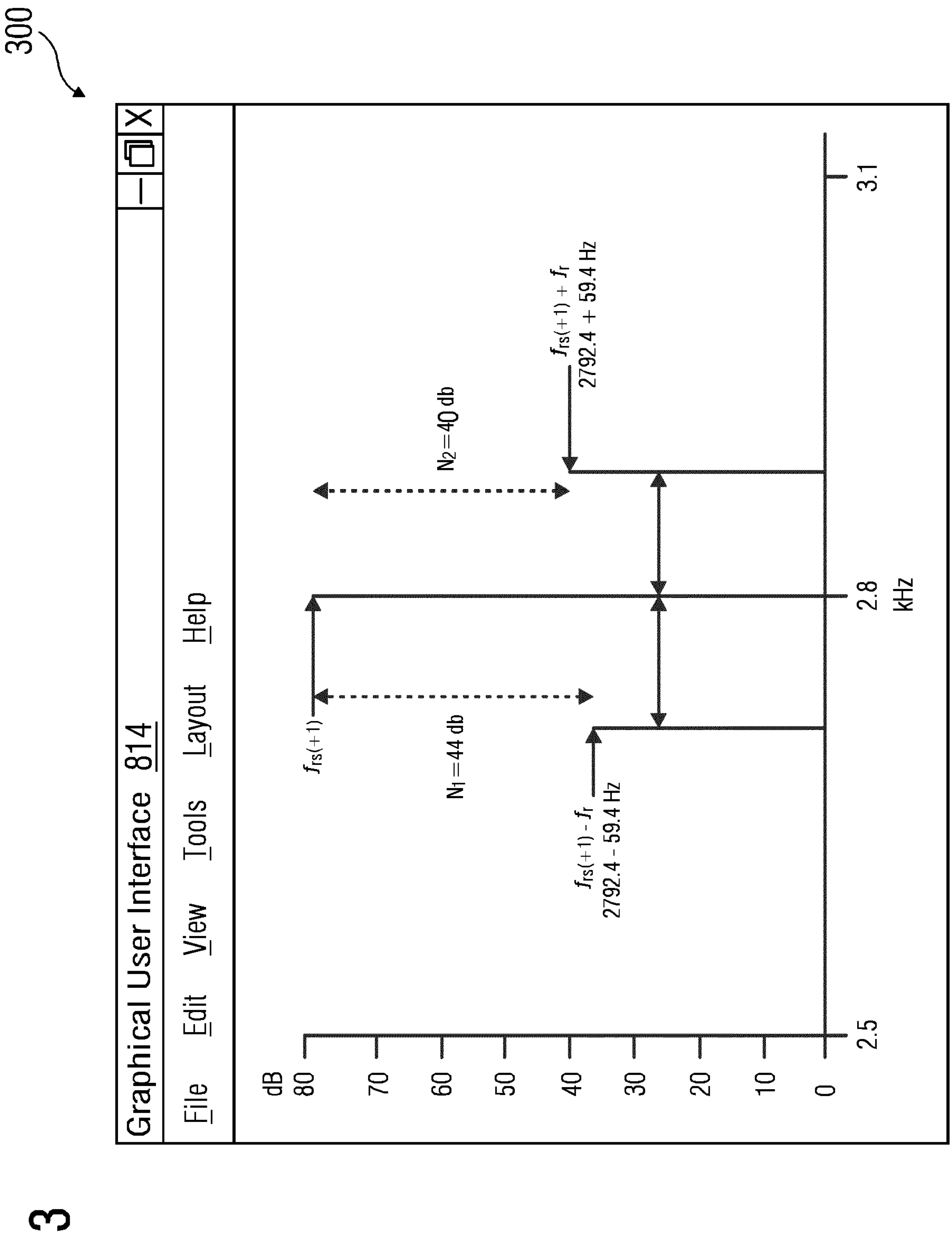
300
Graphical User Interface 814
File
Edit
View
Tools
Layout
Help
dB
80
70
60
50
40
30
20
10
0
2.5
2.8
3.1
kHz
$f_{rs(+1)}$
$N_1$=44 db
$N_2$=40 db
$f_{rs(+1)} - f_r$
2792.4 - 59.4 Hz
$f_{rs(+1)} + f_r$
2792.4 + 59.4 Hz

FIG 4

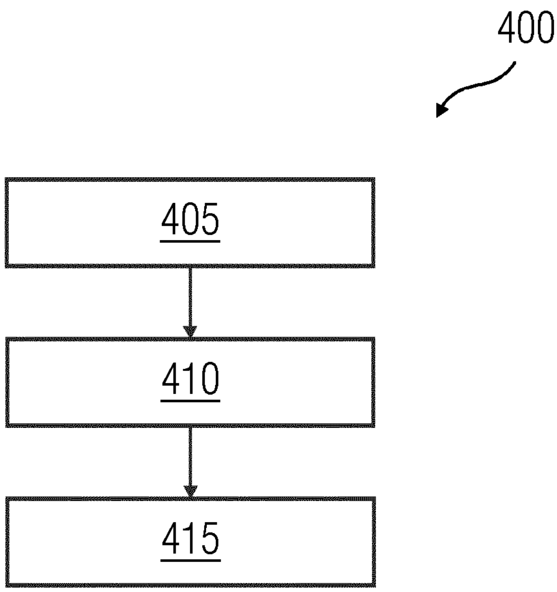

FIG 5

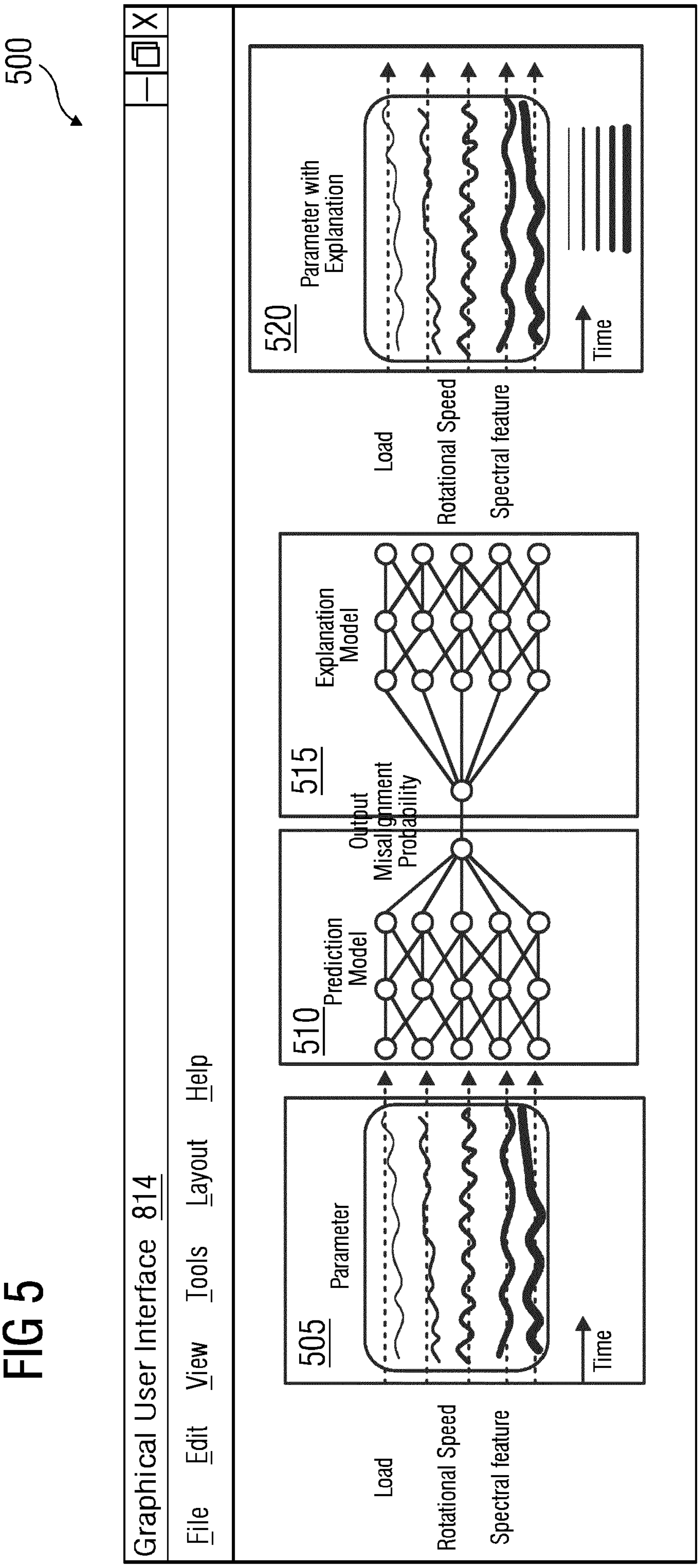
500
Graphical User Interface 814
File
Edit
View
Tools
Layout
Help
505
Parameter
Load
Rotational Speed
Spectral feature
Time
510
Prediction Model
Output Misalignment Probability
515
Explanation Model
520
Parameter with Explanation
Load
Rotational Speed
Spectral feature
Time

FIG 6

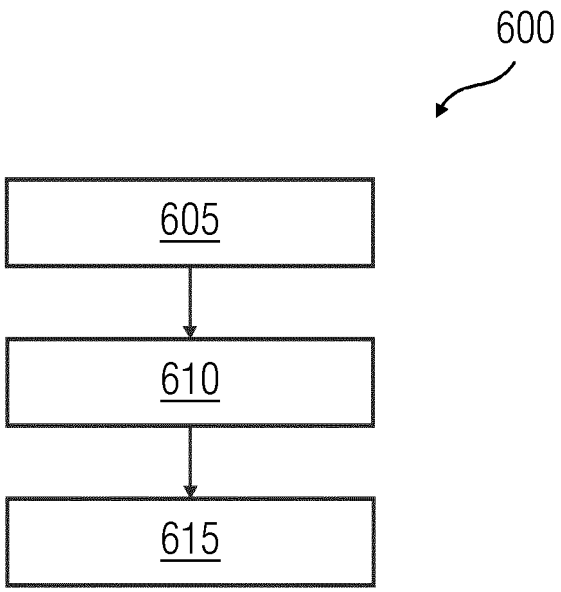

FIG 7

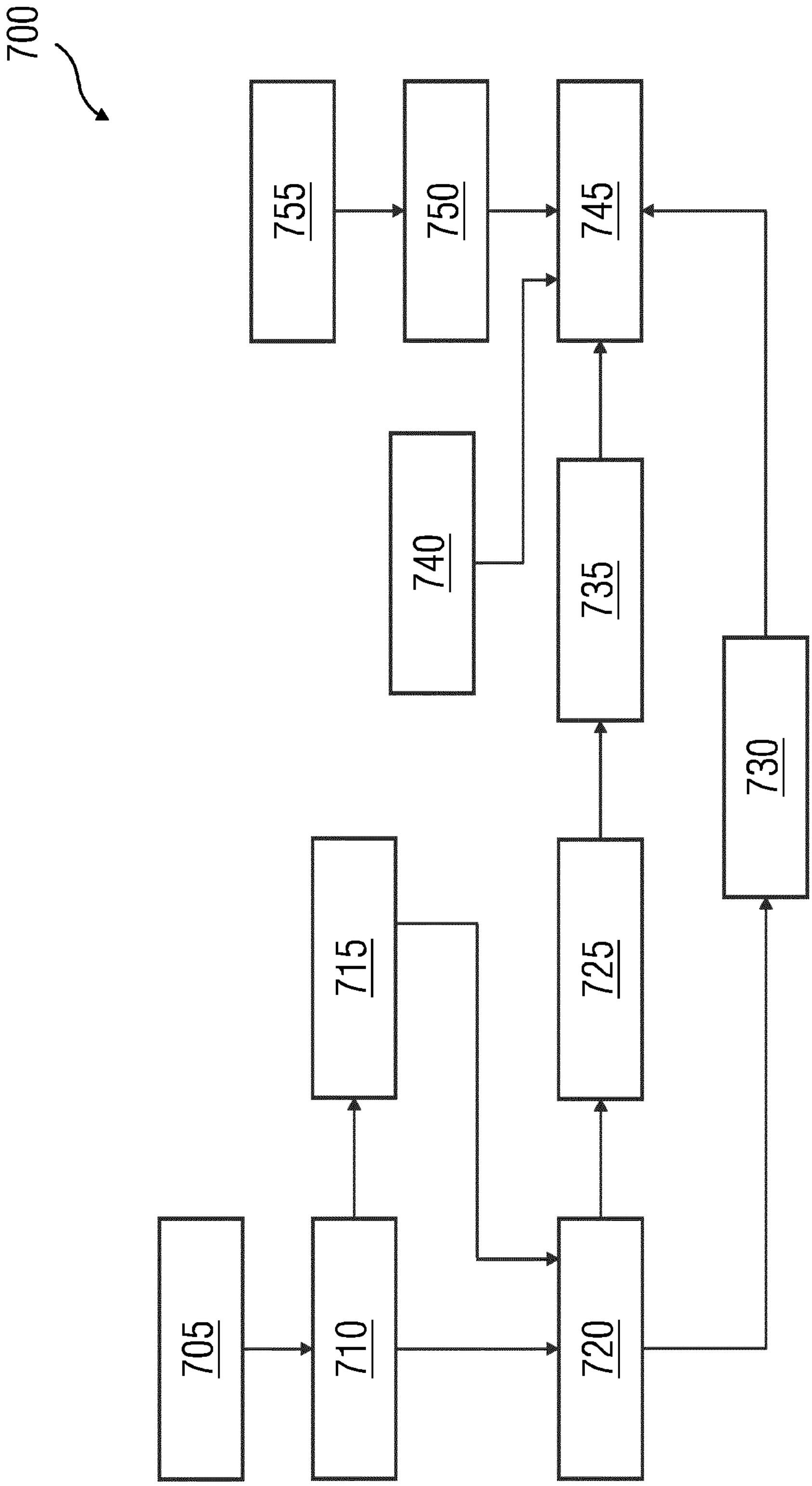

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3904988 A1


### Non-patent literature cited in the description


- An explainable artificial intelligence approach for unsupervised fault detection and diagnosis in rotating machinery. **BRITO LUCAS C et al.** MECHANICAL SYSTEMS AND SIGNAL PROCESSING. ELSEVIER, 17 June 2021, vol. 163